# EUROPÄISCHE PATENTSCHRIFT

(11) **EP 1 320 636 B1**
(45) Veröffentlichungstag und Bekanntmachung des Hinweises auf die Patenterteilung: **21.04.2004**
(21) Anmeldenummer: 01974282.4
(22) Anmeldetag: 22.09.2001
(51) Int. Cl.: C23C 16/448, C23C 16/455

(54) **VERFAHREN UND VORRICHTUNG ZUM ABSCHEIDEN INSBESONDERE ORGANISCHER SCHICHTEN IM WEGE DER OVPD**
METHOD AND DEVICE FOR DEPOSITING ESPECIALLY, ORGANIC LAYERS BY ORGANIC VAPOR PHASE DEPOSITION
PROCEDE ET DISPOSITIF POUR L'EXTRACTION NOTAMMENT DE COUCHES ORGANIQUES DANS LE CADRE DE LA DEPOSITION EN PHASE VAPEUR ORGANIQUE

(30) Priorität: 29.09.2000 DE 10048759
(43) Veröffentlichungstag der Anmeldung: 25.06.2003
(73) Patentinhaber: Aixtron AG, 52072 Aachen (DE)
(72) Erfinder: JÜRGENSEN, Holger, 52072 Aachen (DE); STRAUCH, Gerd, 52072 Aachen (DE); SCHWAMBERA, Markus, 52064 Aachen (DE)
(74) Vertreter: Grundmann, Dirk, Dr.
(86) Internationale Anmeldenummer: PCT/EP2001/010961
(87) Internationale Veröffentlichungsnummer: WO 2002/027064

(56) Entgegenhaltungen:
- EP-A- 0 387 943
- EP-A- 0 714 999
- US-A- 2 704 727
- US-A- 4 947 790
- US-A- 5 186 120
- US-A- 5 227 340
- US-A- 5 904 771

## Beschreibung

Die Erfindung betrifft ein Verfahren zum Abscheiden besonderer organischer Schichten, bei dem in einem beheizten Reaktor ein in einer von einem Behälter gebildeten Quelle bevorrateter, nicht gasförmiger Ausgangsstoff mittels eines Trägergases im gasförmigen Zustand von der Quelle zu einem Substrat transportiert wird, Wo er auf dem Substrat deponiert.

Mit diesen Verfahren werden insbesondere organische Leuchtdioden (OLED) hergestellt. Es wird als OVPD-Verfahren (Organic Vapour Phase Deposition) bezeichnet.
Als Ausgangsstoffe werden organische Moleküle verwendet, die insbesondere als Salze und granulatförmig vorliegen, aber auch im flüssigen Zustand vorliegen können. Diese Moleküle haben einen sehr geringen Dampfdruck. Durch Erwärmung des Ausgangsstoffes tritt dieser in den gasförmigen Zustand im Wege der Sublimation über. Im Stand der Technik ist der Behälter eine oben offene Wanne, in welcher der Ausgangsstoff enthalten ist. Diese Wanne wird in eine Quellenzone des beheizten Reaktors eingeschoben. Der aus der Granulatschüttung oder einer Schmelze verdampfende Ausgangsstoff wird mittels eines Trägergases, beispielsweise Stickstoff durch den Reaktor transportiert. Das Substrat kann sich auf einer Substrattemperatur befinden, die geringer ist als die Quellentemperatur. Dort kann der Ausgangsstoff deponieren. Im Stand der Technik werden Prozessdrucke von 0,2 mbar verwendet.

Die Erfindung betrifft ferner eine Vorrichtung zum Durchführen des Verfahrens mit einer einem beheizbaren

Der Erfindung liegt die Aufgabe zugrunde, Maßnahmen anzugeben, um die Wachstumsraten präziser vorherbestimmen zu können und effizienter als bisher aus dem Stand der Technik bekannt größere Substratflächen zu beschichten. Gelöst wird die Aufgabe durch das im Anspruch 1 angegebene Verfahren bzw. durch die im Anspruch 5 angegebene Vorrichtung.

Der Erfindung liegt die Erkenntnis zugrunde, dass die Quelle zufolge einer nicht reproduzierbar einstellbaren Wärmezufuhr und einer Abkühlung durch das Trägergas eine nicht vorhersagbare Produktionsrate gasförmigen Ausgangsstoffes hat. Was die als nachteilig erachteten schwankenden Wachstumsraten nach sich zieht. Das Verfahren zielt darauf ab, dass das Trägergas vorgeheizt wird und von unten nach oben den zufolge beheizter Behälterseitenwände isotherm zum Trägergas gehaltenen Ausgangsstoff durchspült. Da das in den Behälter einströmende Trägergas dieselbe Temperatur besitzt wie der durch Wärmeübertragung von den Behälterwänden aufgeheizte Ausgangsstoff, findet eine Abkühlung nicht mehr statt. Die Kondensationswärme, die dem insbesondere pulver- oder granulatförmigen Ausgangsstoff bei der Verdampfung entzogen wird, wird über die Seitenwände wieder zugeführt. Zur Unterstützung der Wärmezufuhr können auch Heizstäbe in den Ausgangsstoff ragen. Die Prozessparameter sind vorzugsweise so eingestellt, dass das Trägergas bereits wenige Millimeter nach In-Kontakt-Treten mit dem Ausgangsstoff gesättigt ist. Vorzugsweise findet die Sättigung im unteren Drittel bzw. unteren Fünftel der Aufnahmekammer statt. In einer Variante des Verfahrens kann der Behälter von oben nachgefüllt werden. Bevorzugt wird das Trägergas von derselben Heizung vorgeheizt, die auch den Behälter heizt. Als Behälterwand kommt insbesondere Metall, vorzugsweise Aluminium in Betracht.

Die erfindungsgemäße Vorrichtung zeichnet sich dadurch aus, dass der Behälter einen bodenseitigen Gaseinlass und einen deckelseitigen Gasauslass und zwischen Gaseinlass und Gasauslass eine mit dem Ausgangsstoff auffüllbare Aufnahmekammer besitzt, und den Behälterwänden sowie der in den Gaseinlass mündenden Trägergaszuleitung eine Heizung zugeordnet ist zum isothermen Aufheizen des Trägergases und des Ausgangsstoffes. Die Aufnahmekammer kann auch als Einsatz ausgebildet sein. Dieser Einsatz kann dann ausgewechselt werden. Der Einsatz wird in den Behälter eingesetzt. Er enthält das organische Material. Ist das Material verbraucht oder teilverbraucht, so kann der Einsatz entnommen werden und gegen einen vollen ausgetauscht werden. Der Behälter ist ringsumschlossen und besitzt außer der Einlass- bzw. Auslassöffnung vorzugsweise nur eine Nachfüllöffnung. In einer bevorzugten Ausgestaltung des Behälters liegt über dem Gaseinlass eine gasdurchlässige Zwischenwand, die aus porösem Material bestehen kann. Die Zwischenwand kann als Fritte ausgebildet sein. Auf dieser Zwischenwand liegt der insbesondere pulverförmige oder granulierte Ausgangsstoff als Schüttung. Das Trägergas wird von einer vorgeschalteten Heizung auf die Quellentemperatur gebracht. Dieses Trägergas tritt dann durch die poröse Zwischenwand gleichmäßig hindurch und durchspült die auf der Zwischenwand liegende Schüttung. Es ist auch möglich flüssige Ausgangsstoffe zu verwenden. Dann wird die Flüssigkeit von dem Trägergas durchspült, ähnlich wie es bei einer Waschflasche der Fall ist. Die Zwischenwand kann eben sein, sie kann aber auch kuppeloder konusförmig ausgebildet sein. In einer bevorzugten Ausgestaltung wird das Trägergas und der Behälter von derselben Heizung beheizt. Dies ist'nicht nur bautechnisch vorteilhaft. Es bietet auch eine hohe Gewähr dafür, dass das in den Behälter einströmende Trägergas bereits dort eine Temperatur besitzt, die der Temperatur des Ausgangsstoffes entspricht. In einer Weiterbildung der Vorrichtung ragen in den Ausgangsstoff Heizstäbe ein, die separat beheizt werden können, oder wärmeleitend mit der Behälterwandung verbunden sind, um dem Ausgangsstoff Wärme zuzuführen. Die Aufnabmekammer kann von oben nachfüllbar sein. Oberhalb der Aufnahmekammer kann eine Vorratskammer vorgesehen sein. In dieser Vorratskammer kann sich ein Vorrat des Ausgangsstoffes befinden. Dieser kann über einen verschließbaren Kanal der Aufnahmekammer zugeführt werden, um diese nachzufüllen. Die Vorratskammer braucht nicht beheizt zu sein. Sie kann sogar außerhalb des Reaktors angeordnet sein und nur mit einer Nachfüllverbindung mit dem Reaktor bzw. mit dem Behälter verbunden sein.

Ausführungsbeispiele der Erfindung werden nachfolgend anhand beigefügter Zeichnungen erläutert. Es zeigen:
- Fig. 1: in grob schematisierter Form das Verfahren bzw. die Vorrichtung zur Ausübung des Verfahrens, wie es Stand der Technik ist,
- Fig. 2: ebenfalls nur schematisch dargestellt eine Vorrichtung zur Ausübung des Verfahrens,
- Fig. 3: eine weitere Vorrichtung in schematisierter Darstellung,
- Fig. 4: ein drittes Ausführungsbeispiel einer Vorrichtung in schematisierter Darstellung,
- Fig. 5: ein viertes Ausführungsbeispiel einer Vorrichtung in schematisierter Darstellung und
- Fig. 6: den Verlauf der Anreicherung des Trägergases mit dem gasförmigen Ausgangsstoff als Funktion des Partialdruckes des gasförmigen Ausgangsstoffes im Trägergas vom Ort oberhalb der Zwischenwand.

Beim OVPD-Verfahren wird das Trägergas 4 einem von außen beheizten Reaktor 1 zugeführt. In einer ersten heißen Zone, der Quellenzone I, wird ein Behälter 2 in den Reaktor gegeben, welcher eine Schüttung eines Ausgangsstoffes enthält. Der Ausgangsstoff sublimiert bei der Quellentemperatur. Der gasförmige Ausgangsstoff 5 wird sodann mit dem Trägergas 4 zum Substrat II transportiert, wo es aus der Gasphase kondensiert, um dort eine Schicht abzuscheiden.

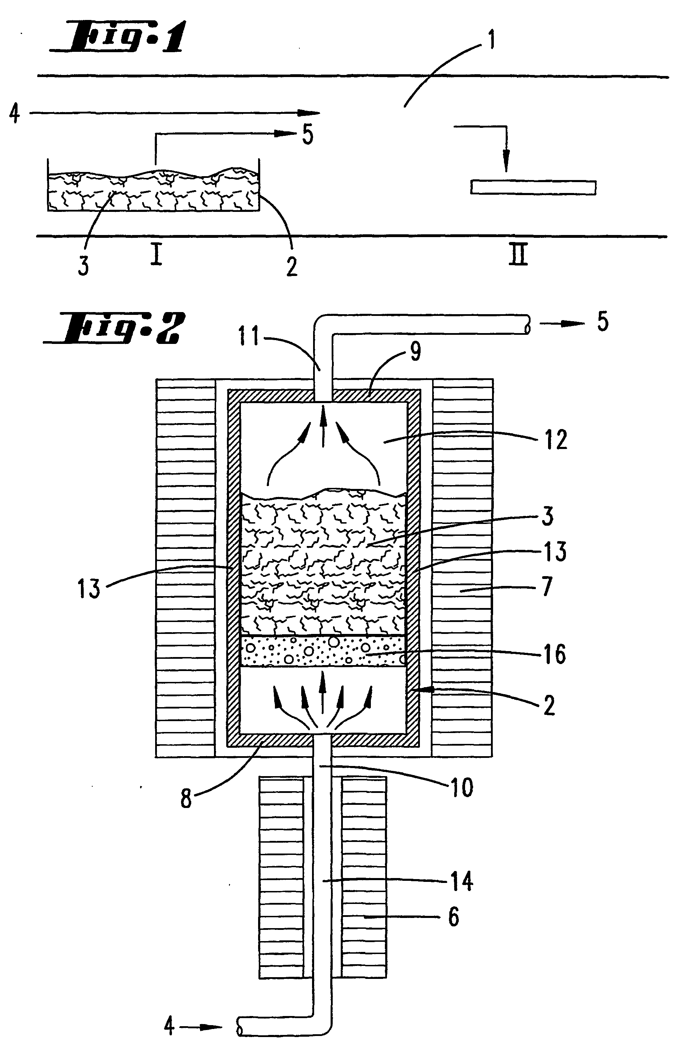

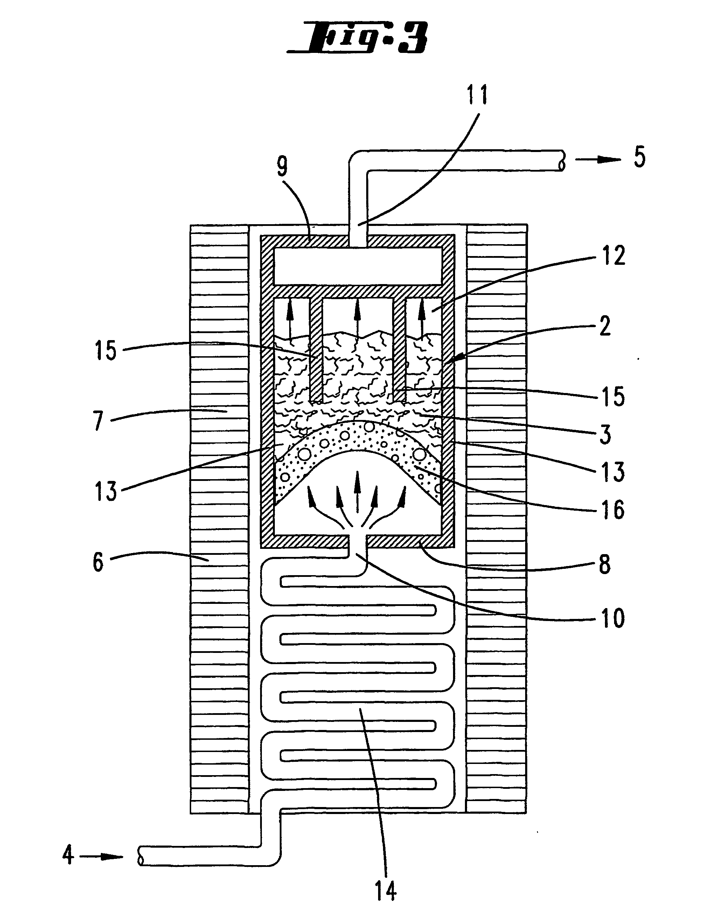

Die in den Fig. 2 bis 5 schematisch dargestellten Vorrichtungen ersetzen den in der Fig. 1 dargestellten wannenförmigen Behälter 2 des Standes der Technik.

Der Behälter 2 ist erfindungsgemäß geschlossen. Er besitzt einen Boden 8, insbesondere zylinderförmige Seitenwände 13 und einen Deckel 9. Der Boden besitzt einen Gaseinlass 10. Der Deckel besitzt einen Gasauslass 11. Im unteren Bereich des aus Metall, insbesondere Aluminium bestehenden Behälters 2 befindet sich ein Einströmraum, in welchen das Trägergas 4, welches durch die Trägergaszuleitung 14 fließt, einströmen kann. Nach oben wird dieser Raum durch eine poröse Zwischenwand 16 begrenzt. Durch diese Zwischenwand tritt der Gasstrom hindurch und in den auf der Zwischenwand 16 geschütteten Ausgangsstoff 3. Der Ausgangsstoff 3 wird von unten nach oben von dem Trägergas 4 durchspült, wobei das Trägergas sich bereits unmittelbar oberhalb der Zwischenwand 16 mit dem gasförmigen Ausgangsstoff sättigt und zusammen mit dem gasförmigen Ausgangsstoff 5 aus dem Gasauslass 11 in den Reaktor austritt. Die ganze Vorrichtung, wie sie in den Fig. 2 bis 5 dargestellt ist, kann in den Reaktor integriert werden. Der Reaktor wird baulich angepasst.

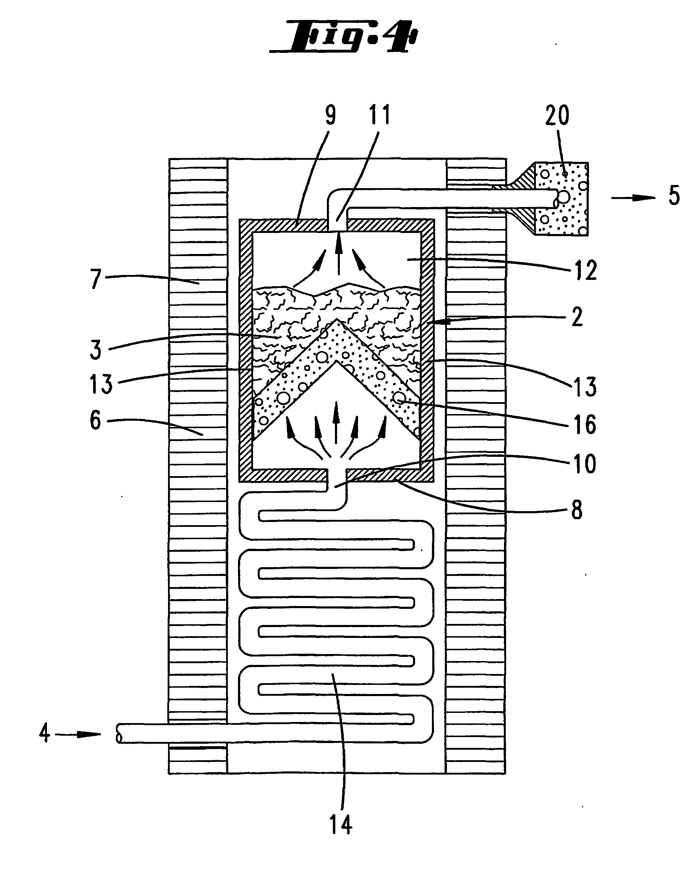

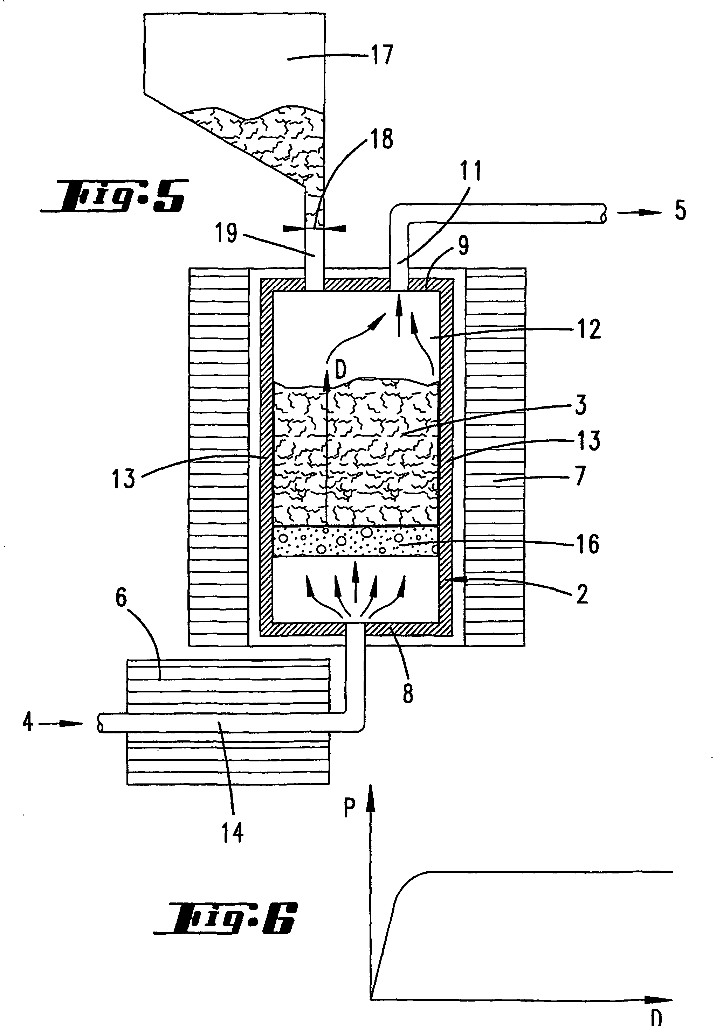

Die Zuleitung 14 wird von einer Heizung 6 beheizt. Diese heizt das Trägergas 4 auf dieselbe Temperatur, die der Ausgangsstoff 3 in der oberhalb der Zwischenwand 16 angeordneten Aufnahmekammer 12 besitzt. Um den Ausgangsstoff 3 mit der Wärmemenge zu versorgen, die beim Verdampfen den Ausgangsstoff 3 entzogen wird, besitzt der Behälter 2 eine Behälterheizung 7. Im Ausführungsbeispiel umgibt die Behälterheizung 7 die äußere Behälterwandung 13, um sie aufzuheizen. Durch Wärmeleitung wird die der Behälterwandung 13 zugeführte Wärme dem Ausgangsstoff 3 zugeführt. Bei dem in den Fig. 3 und 4 dargestellten Ausführungsbeispiel ist die Heizung 6 der Trägergaszuleitung 14 dieselbe Heizung, wie die Behälterheizung 7. Um die Wegstrecke des aufzuheizenden Trägergases 4 zu verlängern, kann die Trägergaszuleitung 14 wendelgangförmig gestaltet sein. Bei dem in Fig. 3 dargestellten Ausführungsbeispiel ist die Zwischenwand 16 kuppelförmig gestaltet. Außerdem ragen dort Heizstäbe 15 in die Schüttung des Ausgangsstoffes 3 hinein. Die Heizstäbe 15 sind wärmeleitverbunden mit der Behälterwandung 13.

Bei dem in Fig. 4 dargestellten Ausführungsbeispiel hat die Zwischenwand 16 eine konische Gestalt. Die Versorgungsleitung für das Trägergas bzw. die Ableitung desselben kann durch Öffnungen einer den Behälter und die Zuleitung 14 umgebenden Heizung 6, 7 erfolgen.

Bei dem in der Fig. 5 dargestellten Ausführungsbeispiel ist die Aufnahmekammer 12 von oben nachfüllbar. Hierzu mündet ein Füllkanal 19 in den Behälterdeckel. Dieser Füllkanal 19 kann mit einem Verschluss 18 verschlossen werden. Oberhalb des Verschlusses befindet sich eine Vorratskammer 17, in welcher sich ein Vorrat des Ausgangsstoffes 3 befindet. Die Vorratskammer kann sich außerhalb des Reaktors befinden und größer sein, als dargestellt.

In der Fig. 6 ist dargestellt, dass der Partialdruck P des Ausgangsstoffes im Trägergas schon bei einer geringfügigen Strecke D oberhalb der Zwischenwand 16 den Sättigungsdruck erreicht hat, so dass eine Quellenverarmung auch dann nicht stattfindet, wenn der Füllstand der Aufnahmekammer 12 absinkt.

Durch die erfindungsgemäßen Maßnahmen ist sichergestellt, dass die als den Quellenumsatz beeinträchtigten Parameter wie Quellentemperatur und freie Oberfläche des Ausgangsmaterials keine nachteiligen Auswirkungen auf die Reproduzierbarkeit der Wachstumsrate mehr besitzen.

Bei dem in der Fig. 4 dargestellten Ausführungsbeispiel ist vor dem Gasauslass in dem Reaktor ein Filter 20 in Form einer Fritte vorgesehen, um zu verhindern, dass Feststoffteilchen oder Tropfen aus dem Behälter in den Reaktor transportiert werden.

In einer derzeit nicht bevorzugten Variante der Erfindung ist ferner vorgesehen, dass das Trägergas mit erhöhter Temperatur in den Behälter gebracht wird. Die Wärme, die zur Sublimation des Ausgangsstoffes erforderlich ist, kann dann zumindest teilweise dem Trägergas entnommen werden, wobei sich das Trägergas dann auf die Behälterwand-Temperatur abkühlt, so dass wieder isotherme Zustände herrschen.

Das Trägergas kann dadurch erwärmt werden, dass die Zwischenwand 16 beheizt wird. Hierzu kann die Zwischenwand 16 aus Metall gefertigt sein.

In den anhand der Figuren erläuterten Ausführungsbeispielen wird der Behälter durchgängig von unten nach oben durchströmt. Die Erfindung umfasst aber auch solche Ausführungsformen, bei denen die Gasströmung anders herum verläuft, nämlich von oben nach unten. Derartige Behälter besitzen dann deckelseitig einen Gaseinlass und bodenseitig einen Gasauslass.

Die Erfindung betrifft ferner auch solche Ausführungsformen, bei denen das organische Material in Einsätzen untergebracht ist, die in den Behälter eingesetzt werden können. Es muss dann nicht das organische Material unmittelbar in den Behälter hineingeschüttet werden. Es kann vorkonfektioniert werden in den Einsätzen. Diese Einsätze können dann in den Behälter eingesetzt werden. Dies ermöglicht insbesondere ein rasches Auswechseln. unterschiedlicher organischer Materialien.

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen.

## Patentansprüche

1. Verfahren zum Abscheiden von Schichten aus einem organischen Material, bei dem ein in einer von einem Behälter (2) gebildeten Quelle (I) bevorrateter, nicht gasförmiger Ausgangsstoff (3), der einen niedrigen Dampfdruck aufweist, mittelst eines Trägergases (4) im gasförmigen Zustand zu einem Substrat (II) transportiert wird, wobei sich das Substrat in einem beheizten Reaktor (1) befindet, und der gasförmige Ausgangsstoff infolge einer Substrattemperatur, die geringer ist als die Quellentemperatur, auf dem Substrat die Schicht bildend kondensiert, wobei die Wände des Behälters (2) mit einer Heizung (6) beheizt werden und das Trägergas von unten nach oben den im Behälter (2) bevorrateten Ausgangsstoff durchspült, wobei die Temperatur des einströmenden Trägergases der Temperatur des Ausgangsstoffes entspricht.

2. Verfahren nach Anspruch 1, **dadurch gekennzeichnet, dass** dem Ausgangsstoff (3) die Verdampfungswärme über die Behälterwände (13) und/oder über in den Ausgangsstoff (3) ragende Heizstäbe (15) zugeführt wird.

3. Verfahren nach einem der vorhergehenden Ansprüche, **dadurch gekennzeichnet, dass** das Trägergas bereits im unteren Drittel bevorzugt unteren Fünftel der Aufnahmekammer mit dem gasförmigen Ausgangsstoff gesättigt ist

4. Verfahren nach einem der vorhergehenden Ansprüche, **dadurch gekennzeichnet, dass** der Behälter (2) von oben nachgefüllt wird.

5. Vorrichtung zur Durchführung eines Verfahrens gemäß einem der vorhergehenden Ansprüche, mit einer einem beheizten Reaktor vorgeordneten Quelle (I) in Form eines Behälters (2) zur Aufnahme eines nicht gasförmigen Ausgangsstoffes (3), wobei der Behälter (2) unten einen Einlass (10), oben einen Gasauslass (11) und zwischen Gaseinlass (10) und Gasauslass (11) eine mit dem Ausgangsstoff (3) auffüllbare Aufnahmekammer (12) besitzt, und den Behälterwänden (13) sowie der in den Gaseinlass (10) mündenden Trägergaszuleitungen (14) eine gemeinsame Heizung (6, 7) zugeordnet ist, zum isothermen Aufheizen des Trägergases (4) und des Ausgangsstoffes (3).

6. Vorrichtung nach Anspruch 5, **dadurch gekennzeichnet, dass** der Behälter (2) eine vom Gaseinlass beabstandete, gasdurchlässige Zwischenwand (16) besitzt, auf welcher der insbesondere pulverförmige oder granulierte Ausgangsstoff liegt.

7. Vorrichtung nach Anspruch 6, **dadurch gekennzeichnet, dass** die Zwischenwand (16) eben, kuppel- oder konusförmig ist

8. Vorrichtung nach einem der vorhergehenden Ansprüche, **gekennzeichnet durch** in die Aufnahme (12) ragende Heizstäbe (15).

9. Vorrichtung nach einem der vorhergehenden Ansprüche, **gekennzeichnet durch** eine oberhalb der Aufnahmekammer (12) angeordnete Vorratskammer (17), welche mit der Aufnahmekammer (12) über einen abschottbaren Kanal (19) verbunden ist

10. Vorrichtung nach einem der vorhergehenden Ansprüche, **dadurch gekennzeichnet, dass** die Zwischenwand (16) beheizbar ist und insbesondere aus Metall besteht.

11. Vorrichtung nach einem der vorhergehenden Ansprüche, **dadurch gekennzeichnet, dass** der Gasauslass (11) einen Filter insbesondere in Form einer Fritte aufweist.

12. Vorrichtung nach einem der vorhergehenden Ansprüche, **gekennzeichnet durch** einen mit dem organischen Material auffüllbaren Einsatz, welcher in den Behälter (2) einbringbar ist und welcher eine gasdurchlässige Einsatzwand besitzt, welche von dem den Behälter durchströmenden Gas durchströmbar ist.

## Claims

1. Method for depositing layers of an organic material, in which a non-gaseous starting material (3), which is held in stock in a source (I) formed by a vessel (2) and has a low vapor pressure, is transported in the gaseous state, by means of a carrier gas (4), to a substrate (II), the substrate being located in a heated reactor (1) and the gaseous starting material, on account of a substrate temperature which is lower than the source temperature, condensing on the substrate so as to form the layer, the walls of the vessel (2) being heated by a heating means (6), and the carrier gas flushing through the starting material, which is held in stock in the vessel (2), from the bottom upward, the temperature of the carrier gas flowing in corresponding to the temperature of the starting material.

2. Method according to Claim 1, **characterized in that** the heat of evaporation is fed to the starting material (3) via the vessel walls (13) and/or via heating rods (15) which project into the starting material (3).

3. Method according to one of the preceding claims, **characterized in that** the carrier gas is already saturated with the gaseous starting material within the bottom third, preferably bottom fifth, of the receiving chamber.

4. Method according to one of the preceding claims, **characterized in that** the vessel (2) is topped up from the top.

5. Device for carrying out a method according to one of the preceding claims, having a source (I), which is located upstream of a heated reactor, in the form of a vessel (2) for receiving a non-gaseous starting material (3), the vessel (2) having an inlet (10) at the bottom, a gas outlet (11) at the top, and, between gas inlet (10) and gas outlet (11), a receiving chamber (12) which can be filled with the starting material (3), and a common heating means (6, 7) for isothermal heating of the carrier gas (4) and of the starting material (3) being associated with the vessel walls (13) and the carrier-gas feed lines (14) which open out into the gas inlet (10).

6. Device according to Claim 5, **characterized in that** the vessel (2) has a gas-permeable partition (16), which is at a spacing from the gas inlet and on which the starting material, which is in particular in powder or granule form, is located.

7. Device according to Claim 6, **characterized in that** the partition (16) is planar or in the shape of a dome or a cone.

8. Device according to one of the preceding claims, **characterized by** heating rods (15) which project into the receptacle (12).

9. Device according to one of the preceding claims, **characterized by** a storage chamber (17) which is disposed above the receiving chamber (12) and is connected to the receiving chamber (12) via a passage (19) which can be blocked off.

10. Device according to one of the preceding claims, **characterized in that** the partition (16) is heatable and in particular consists of metal.

11. Device according to one of the preceding claims, **characterized in that** the gas outlet (11) has a filter, in particular in the form of a frit.

12. Device according to one of the preceding claims, **characterized by** an insert which can be filled with the organic material, can be introduced into the vessel (2) and has a gas-permeable insert wall through which the gas flowing through the vessel can flow.

## Revendications

1. Procédé de déposition de couches à base d'un matériau organique, dans lequel une substance de départ (3) non gazeuse stockée dans une source (I) constituée d'un réservoir (2) et qui comporte une faible tension de vapeur, est transportée à l'état gazeux vers un substrat (II) au moyen d'un gaz vecteur (4), sachant que le substrat se trouve dans un réacteur (1) chauffé et que la substance de départ gazeuse, du fait que la température du substrat, qui est plus basse que la température de la source, se condense en formant une couche sur le substrat, les parois du réservoir (2) chauffés par un dispositif de chauffage (6) et le gaz vecteur parcourant de bas en haut la substance de départ stockée dans le réservoir (2), et la température du gaz vecteur affluent correspondant à la température de la substance de départ.

2. Procédé selon la revendication 1, **caractérisé en ce que** la chaleur latente d'évaporation est fournie à la substance de départ (3) via les parois du réservoir (13) et/ou via des baguettes chauffantes (15) faisant saillie dans la substance de départ (3).

3. Procédé selon l'une des revendications précédentes, **caractérisé en ce que** le gaz vecteur est saturé en substance de départ gazeuse dès le tiers inférieur, de préférence dès le cinquième inférieur de la chambre d'admission.

4. Procédé selon l'une des revendications précédentes, **caractérisé en ce que** le réservoir (2) est rempli par le haut.

5. Dispositif d'exécution d'un procédé selon l'une des revendications précédentes, avec une source (I) constituée d'un réservoir (2) disposée à l'avant d'un réacteur chauffé, réservoir admettant une substance de départ (3) non gazeuse, sachant que le réservoir (2) possède en bas une entrée (10), en haut une sortie (11) pour le gaz et entre l'entrée (10) pour le gaz et la sortie (11) pour le gaz une chambre d'admission (12) que l'on peut remplir de la substance de départ (3), et qu'un dispositif de chauffage commun (6, 7) est adjoint aux parois du réservoir (13) ainsi qu'aux conduites d'amenée (14) de gaz vecteur débouchant dans l'entrée (10) pour le gaz, pour réchauffer de façon isotherme le gaz vecteur (4) et la substance de départ (3).

6. Dispositif selon la revendication 5, **caractérisé en ce que** le réservoir (2) possède une cloison (16) perméable aux gaz écartée de l'entrée pour le gaz, et sur laquelle repose la substance de départ, en particulier granulée ou sous forme poudreuse.

7. Dispositif selon la revendication 6, **caractérisé en ce que** la cloison (16) est plane, en forme de calotte, ou conique.

8. Dispositif selon l'une des revendications précédentes, **caractérisé par** des baguettes chauffantes (15) faisant saillie dans l'admission (12).

9. Dispositif selon l'une des revendications précédentes, **caractérisé par** une réserve (17) disposée au-dessus de la chambre d'admission (12), laquelle réserve est reliée à la chambre d'admission (12) par un canal (19) que l'on peut fermer.

10. Dispositif selon l'une des revendications précédentes, **caractérisé en ce que** la cloison (16) peut être chauffée et se compose en particulier de métal.

11. Dispositif selon l'une des revendications précédentes, **caractérisé en ce que** la sortie (11) pour le gaz comprend un filtre, en particulier sous la forme d'un fritté.

12. Dispositif selon l'une quelconque des revendications qui précèdent, **caractérisé par** une garniture que l'on peut remplir du matériau organique, laquelle garniture peut être introduite dans le réservoir (2) et possède une paroi de garniture perméable aux gaz, laquelle paroi peut être traversée par le gaz qui balaie le réservoir.
